# FASCICULE DE BREVET EUROPEEN

(11) **EP 2 750 168 B1**
(45) Date de publication et mention de la délivrance du brevet: **25.07.2018**
(21) Numéro de dépôt: 13199534.2
(22) Date de dépôt: 24.12.2013
(51) Int. Cl.: H01L 21/308, H01L 21/311, H01L 21/3213

(54) **Procédé de gravure anisotrope**
Verfahren zur anisotropen Ätzung
Anisotropic etching method

(30) Priorité: 28.12.2012 FR 1262954
(43) Date de publication de la demande: 02.07.2014
(73) Titulaire: COMMISSARIAT À L'ÉNERGIE ATOMIQUE ET AUX ÉNERGIES ALTERNATIVES, 75015 Paris (FR); Applied Materials, Inc., Santa Clara, CA 95050 (US)
(72) Inventeur: Posseme, Nicolas, 38000 GRENOBLE (FR); Lee, Gene, San Jose, CA 95129 (US)
(74) Mandataire: Hautier, Nicolas

(56) Documents cités:
- US-A1- 2007 123 050

## Description

### DOMAINE TECHNIQUE DE L'INVENTION

La présente invention concerne en général les techniques de gravure utilisées en microélectronique et plus particulièrement celles basées sur l'utilisation d'un masque dur dans un réacteur de gravure plasma.

### ÉTAT DE LA TECHNIQUE

La réduction constante des dimensions des motifs qu'il faut pouvoir graver pour réaliser des circuits intégrés toujours plus denses n'a pu être soutenue qu'en améliorant constamment les techniques de photolithographie et de gravure des couches de matériaux employés pour réaliser les circuits intégrés électroniques. Alors que les familles de circuits intégrés ou «noeuds» technologiques atteignent désormais des tailles de quelques dizaines de nanomètres (nm = 10⁻⁹ mètre) il faut pouvoir prolonger la décroissance des dimensions au-delà des noeudstechnologiques qui se sont succédés dans les années passées : 90, 65 et 45 nm jusqu'au noeud actuellement en production dans les chaînes les plus récentes, c'est-à-dire 32 nm.

Ainsi, pour atteindre les dimensions décananométriques ci-dessus, on a le plus souvent recours désormais à l'utilisation, en photolithographie, d'un « masque dur » vocable traduit de l'anglais « hard mask » (HM) et qui fait référence à l'emploi d'une couche intermédiaire pour pouvoir graver avec une bonne définition les motifs les plus petits. Alors que pendant longtemps les résines photosensibles servaient directement de masque, après développement des motifs et insolation, pour graver ceux-ci dans les matériaux formant les circuits intégrés, dont les plus courants sont le silicium (Si) et son oxyde (SiO2), on commence le plus souvent maintenant par graver d'abord les motifs dans une couche d'un matériau constituant le masque dur.

Cette technique est notamment devenue nécessaire car la gravure elle-même a beaucoup évoluée. Alors qu'elle a longtemps été effectuée dans un milieu humide, c'est-à-dire en mettant en contact les surfaces à graver avec une solution chimique appropriée, on procède souvent désormais à une gravure par bombardement ionique à l'aide d'un plasma formé dans une chambre de gravure. En effet, les gravures humides sont essentiellement isotropes. La gravure s'étend aussi bien en profondeur que sous les résines servant alors de masque. Avec la réduction des dimensions des motifs jusqu'aux dimensions décananométriques mentionnées plus haut il devient impossible avec ce type de gravure de respecter les dimensions critiques, ou CD de l'anglais « critical dimensions », des dispositifs à produire. Le facteur de forme des motifs à graver a en effet énormément changé au fil d'années de développement. L'augmentation constante de la densité des circuits est obtenue essentiellement avec une réduction de géométrie des motifs alors que les épaisseurs des couches dans lesquelles ils sont formés n'ont pas variées, et de loin, dans une même proportion. Il a donc fallu avoir recours à un type de gravure fortement anisotrope. C'est ce que permet la gravure dans un plasma. Le bombardement des ions étant essentiellement perpendiculaire aux surfaces à graver il y a alors, dans des conditions optimales de mise en oeuvre, peu ou pas d'attaque latérale des matériaux à graver et on peut atteindre les dimensions critiques.

L'utilisation d'une gravure plasma anisotrope implique cependant en pratique l'utilisation d'un masque dur car la sélectivité d'attaque de ce type de gravure en fonction des matériaux sur lesquels elle agit est malheureusement beaucoup plus faible que celle que l'on peut obtenir avec les gravures humides. Pour continuer à utiliser directement les résines photosensibles comme masque il faudrait en effet les déposer en couches très épaisses pour qu'elles ne soient pas entièrement consommées à l'issue de la gravure ce qui est alors incompatible avec la définition de dimensions critiques (CD) dans ces résines.

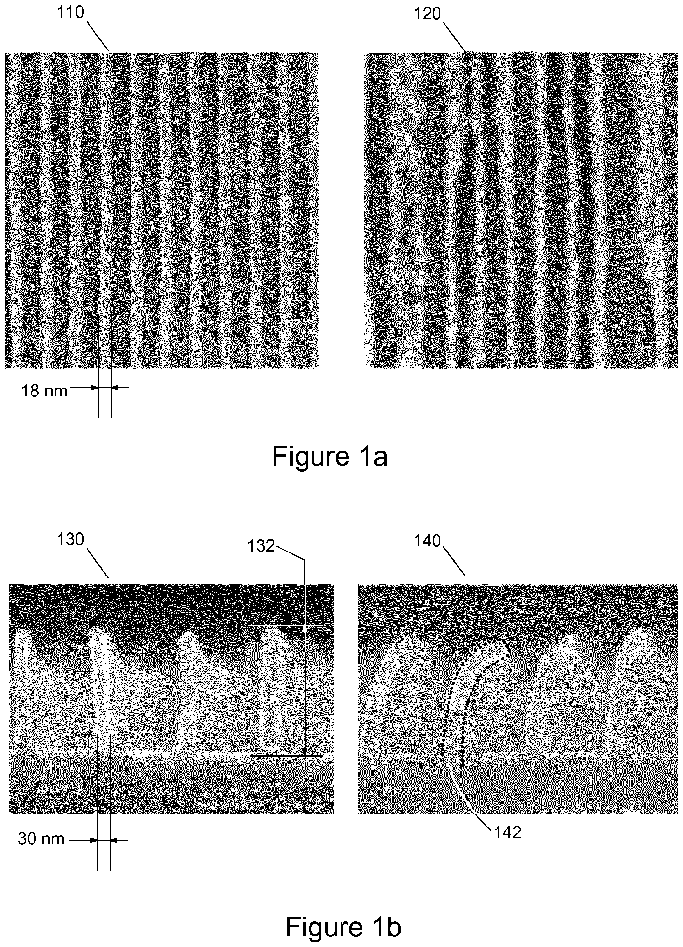

La solution consiste à réaliser un masque dur dans un matériau suffisamment résistant à la gravure plasma et dans lequel les motifs à graver sont d'abord transférés. Traditionnellement, avec les noeuds technologiques depuis celui de 90 nm, le matériau le plus souvent utilisé par l'industrie de la microélectronique pour réaliser un masque dur est le carbone. Cependant, comme on va le voir dans la description des figure 1a et 1b, les nouvelles réductions de dimensions nécessaires pour mettre en oeuvre les noeuds technologiques en cours de développement, c'est-à-dire ceux au-delà de 32 nm, font que ce matériau et la technique de gravure associée ne conviennent plus en raison des déformations de masque dur constatées lors de la mise en oeuvre du procédé traditionnel.

US 2007/123050 A1 divulgue un procédé de gravure anisotrope de motifs dans une couche à graver à travers un masque dur fait de bore dopé au carbone. C'est donc un objet de l'invention que d'apporter une solution de gravure qui soit compatible avec les noeuds technologiques en cours de développement et avec les exigences industrielles en termes de cadence de production.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

L'invention porte sur un procédé de gravure anisotrope de motifs dans au moins une couche à graver, comprenant par exemple un matériau semi-conducteur, à travers un masque dur dans un réacteur de gravure plasma à couplage inductif (ICP). Le masque dur est fait de bore dopé au carbone (B:C). Préalablement à la gravure anisotrope des motifs dans ladite couche à graver à travers le masque dur de bore dopé au carbone (B:C) on effectue les étapes suivantes:
- réalisation d'un masque dur intermédiaire situé sur une couche de bore dopé au carbone destinée à former le masque dur fait de bore dopé au carbone (B:C),
- gravure de la couche de bore dopé au carbone (B:C) à travers le masque dur intermédiaire pour définir lesdits motifs dans le masque dur fait de bore dopé au carbone (B:C), la gravure du masque dur de bore dopé au carbone (B:C) étant réalisée dans un plasma fait d'espèces comprenant : du chlore (Cl₂), de l'argon (Ar), un gaz à base d'oxygène et un gaz fluoré,
la réalisation du masque dur intermédiaire et la gravure du masque dur fait de bore dopé au carbone (B:C) étant réalisées dans ledit réacteur de gravure plasma à couplage inductif (ICP).

Il a été constaté que l'utilisation d'un tel masque dur de bore dopé au carbone dans un réacteur plasma à couplage inductif permet de réduire les distorsions de masque qui surviennent avec les solutions utilisant un masque de carbone, permet de réaliser une gravure fortement anisotrope de ladite couche à graver et permet d'effectuer l'ensemble des étapes dans un même réacteur ce qui augmente la productivité. Il s'avère que la sélectivité à la gravure du masque de bore dopé au carbone est significativement plus élevée que la sélectivité à la gravure d'un masque de carbone. Ainsi, lors de la gravure de ladite couche à graver, le masque de bore dopé au carbone se consomme bien moins vite, typiquement trois fois moins vite, qu'un masque de carbone. Il s'ensuit que l'épaisseur du masque de bore dopé au carbone peut être réduite par rapport à un masque de carbone tout en réalisant une gravure de ladite couche à graver fortement anisotrope. Il a été observé que les défauts qui surviennent habituellement avec les masques de carbone, telle que le repliement des motifs fins de carbone, apparaissent d'autant plus facilement que l'épaisseur du masque de carbone est importante. L'invention, en permettant de réduire l'épaisseur du masque à travers lequel ladite couche à graver est gravée, permet donc de réduire les défauts apparaissant au niveau du masque.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a et 1b illustrent les problèmes posés par l'utilisation d'un masque dur en carbone pour les noeuds technologiques au-delà de 32 nm.
Les FIGURES 2a à 2d illustrent les étapes d'un exemple de procédé selon l'invention dans lequel on réalise une gravure anisotrope des motifs d'un masque dur en bore dopé au carbone (B:C) dans un réacteur de gravure à couplage inductif (ICP).

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches ne sont pas représentatives de la réalité.

### DESCRIPTION DÉTAILLÉE DE L'INVENTION

Il est précisé que dans le cadre de la présente invention, le terme « sur », « surmonte » ou « sous jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans le cadre de la présente invention, on rappelle qu'on qualifie usuellement de masque dur un masque réalisé en un matériau qui ne s'élimine pas lors de l'élimination de masques en résine couramment utilisés dans la technique. Un masque dur se différencie d'un masque polymère ou d'un masque formé par une couche de résine qui après développement permet de transférer des motifs dans une couche qui lui est sous jacente. Le masque dur est disposé entre le masque de résine et la couche à graver. Un masque dur est habituellement un masque inorganique. Il est conventionnellement qualifié de « hard mask » en anglais.

Avant d'entamer une revue détaillée de modes de réalisation de l'invention, sont énoncées ci-après des caractéristiques optionnelles qui peuvent éventuellement être utilisées en association ou alternativement :
- Selon l'invention, la gravure du masque dur de bore dopé au carbone (B:C) est réalisée dans un plasma fait d'espèces comprenant : du chlore (Cl2), de l'argon (Ar), un gaz à base d'oxygène et un gaz fluoré. De préférence, le plasma comprend uniquement ces espèces.
- Avantageusement, le chlore (Cl2) est introduit avec un débit compris entre 2 et 300 sccm et préférence entre 5 et 200 sccm.
- De préférence, l'argon (Ar) est introduit avec un débit compris entre 300 et 700 sccm et de préférence d'environ 500 sccm.
- De préférence, le gaz à base d'oxygène est pris parmi : l'oxygène (02), le dioxyde de soufre (SO2) ou l'oxysulfure de carbone (COS). De préférence, le gaz à base d'oxygène est de l'oxygène (02). De préférence, il est introduit avec un débit compris entre 10 à 80 sccm et préférence entre 20 et 60 sccm.
- Avantageusement, le gaz fluoré est pris parmi : le trifluorure d'azote (NF3) ou l'hexafluorure de soufre (SF6). De préférence, le gaz fluoré est introduit avec un débit compris entre 3 à 50 sccm et préférence entre 5 et 30 sccm.
- Avantageusement, l'épaisseur du masque dur fait de bore dopé au carbone, est comprise entre 1 et 5 fois la profondeur des motifs gravés dans ladite couche à graver.
- Avantageusement, dans le masque dur fait de bore dopé au carbone, la proportion de carbone est comprise entre 15% et 60% et de préférence entre 20% et 50%, ce qui permet d'améliorer la sélectivité.
- Avantageusement, le masque dur fait de bore dopé au carbone comprend du bore (B), du carbone (C) et de l'hydrogène (H) et dans lequel la proportion de bore (B) est comprise entre 20% et 60% et de préférence entre 40% et 55%. Avantageusement, la proportion de carbone (C) est comprise entre 15% et 60% et de préférence entre 20% et 50%. Avantageusement, la proportion d'hydrogène (H) est comprise entre 5% et 40% et de préférence entre 10% et 30%, les proportions étant des proportions molaires.
- Le masque dur est inorganique.
- Avantageusement, le masque dur intermédiaire est fait d'un oxyde. De préférence, le masque dur intermédiaire est fait d'oxyde de silicium (SiO2) ou d'oxyde de silicium nitruré de type SiOxNy.
- Selon un mode de réalisation, la réalisation du masque dur intermédiaire comprend une gravure de la couche intermédiaire dans un plasma fluorocarboné. De préférence, la gravure de la couche intermédiaire pour former le masque dur intermédiaire est réalisée dans un plasma fluorocarboné à base de tétrafluorure de carbone (CF4) ou d'octafluorobutane (C4F8), de trifluorométhane (CHF3) et d'oxygène.
- Avantageusement, la réalisation du masque dur intermédiaire comprend une gravure de la couche intermédiaire à travers un masque de résine située sur la couche intermédiaire.
- Selon un mode de réalisation, ladite couche à graver est faite à base d'un matériau semi-conducteur pris parmi le silicium, le germanium, le silicium-germanium. Selon un autre mode de réalisation, ladite couche à graver comprend un oxyde d'un matériau semi-conducteur pris par exemple parmi le silicium, le germanium ou le silicium-germanium.
- De préférence, préalablement à la réalisation du masque dur intermédiaire on réalise un empilement de couches comprenant au moins ladite couche à graver sur laquelle sont successivement disposées : la couche de bore dopé au carbone ; une couche intermédiaire, de préférence faite d'une oxyde, dans laquelle le masque dur intermédiaire est destiné à être réalisé ; une couche de résine de préférence photosensible.
- De préférence, la couche intermédiaire est disposée directement au contact de la couche de résine. De préférence, la couche intermédiaire est disposée directement au contact de la couche de bore dopé au carbone. De préférence, la couche de bore dopé au carbone est disposée directement au contact de ladite couche à graver.

Comme on l'a vu dans la section sur l'état de la technique les procédés de fabrication actuels de circuits intégrés font le plus souvent appel à l'utilisation de masques durs en carbone. Ce matériau est déposé sous forme liquide par centrifugation ou par voie chimique en phase vapeur à l'aide d'une technique dite PECVD, acronyme de l'anglais « plasma-enhanced chemical vapor déposition » c'est-à-dire « dépôt chimique en phase vapeur assisté par plasma ». Par photolithographie on transfert ensuite dans la couche de carbone les motifs à graver, par exemple, les lignes d'interconnexions et les trous de contact servant à former les vias. Le procédé est utilisé pour les étapes de fabrication dites « BEOL », acronyme de l'anglais « back-end of line » c'est-à-dire les opérations de fin de ligne de fabrication où l'on réalise à relativement basse température, n'excédant pas 450°C, toutes les interconnexions entre les composants actifs. Le procédé est aussi utilisé pour la définition des motifs des composants actifs, les transistors, lors des opérations qualifiées de « FEOL », acronyme de l'anglais « front-end of line » qui fait référence aux opérations de début de ligne de fabrication où des températures plus élevées doivent être appliquées lors de ces étapes préliminaires de réalisation des composants. La fabrication de dispositifs particulièrement denses comme les mémoires électroniques fait également appel à l'utilisation de masques durs pour la gravure.

Cependant, comme montré dans les **figures 1a et 1b** pour les noeuds technologiques au-delà de 32 nm on peut observer des distorsions du masque dur qui sont produites par les opérations qui suivent le transfert des motifs dans la couche de carbone. Suivant les étapes du procédé de fabrication où le masque dur est utilisé on peut avoir à pratiquer ensuite, par exemple, un nettoyage humide à l'aide de solutions à base d'acide fluorhydrique (HF) ou une opération de gravure utilisant une chimie dans un plasma à base de produits fluorocarbonés (FC). Ces opérations s'avèrent être particulièrement perturbantes pour les motifs du masque dur dont le facteur de forme (hauteur/largeur) croît beaucoup en raison de la diminution de la taille des motifs qu'il faut pouvoir graver et en raison de l'épaisseur que le masque doit nécessairement présenter pour ne pas être entièrement consommé lors de la gravure.

La **figure 1a** montre, d'une part, une vue de dessus 110 réalisée avec un microscope électronique d'un exemple de masque dur après ouverture des motifs dans la couche de carbone. Dans cet exemple les lignes du masque ont, comme indiqué, une largeur de 18 nm et sont bien régulièrement espacées après ouverture. La figure 1a montre 120 d'autre part les mêmes lignes après qu'une opération de nettoyage humide a été effectuée. On peut constater que les lignes du masque dur sont alors sérieusement perturbées et sont devenues inutilisables. La figure 1a correspond au cas d'une opération de gravure effectuée lors des étapes FEOL et d'un masque dur disposé sur une couche de silicium. Dans cet exemple l'épaisseur de la couche de carbone est de 70 nm ce qui donne un rapport de forme des motifs très accentué (70/38) qui explique qu'ils puissent être facilement déformés.

La **figure 1b** montre, d'une part, une vue en coupe 130 d'un masque dur après ouverture des motifs dans la couche de carbone 132. La figure 1b montre d'autre part la même vue en coupe 140 après exposition à un plasma de gravure à base de produits fluorocarbonés mentionné ci-dessus. Cet exemple illustre les opérations de gravure où l'on réalise les interconnexions entre composants lors des étapes dites de BEOL. Il s'agit par exemple de graver dans un matériau diélectrique poreux, dont la constante diélectrique est faible, des tranchées qui vont être ensuite remplies de cuivre selon le procédé dit damascène afin d'obtenir des interconnexions à faible constante de temps. On remarque que les motifs en carbone du masque dur, qui ont dans cet exemple une largeur de 30 nm, ont fortement fléchis 142 sur eux-mêmes après exposition au plasma fluorocarboné en raison de leur facteur de forme devenu très défavorable dus aux réductions des dimensions horizontales des motifs à graver. Ce fléchissement des motifs du masque peut être qualifié de « line bending » en anglais.

Une solution aux problèmes exposés dans les figures précédentes serait de pouvoir réduire l'épaisseur de masque dur en carbone afin d'obtenir un facteur de forme des motifs plus favorable à leur tenue mécanique lors des opérations qui suivent leur formation. Cependant, comme on l'a vu dans le chapitre sur l'état de la technique, les gravures plasma se caractérisent par une plus faible sélectivité d'attaque des matériaux exposés à la gravure que celle obtenue avec les gravures humides. Il y a consommation du masque dur lors de la gravure et il n'est pas possible de réduire l'épaisseur de carbone qui a déjà été fixée à la valeur minimale compatible avec ce mode de gravure.

Pour répondre à ces problèmes l'invention propose d'utiliser un autre matériau que le carbone. Ce matériau est du bore (B) dopé au carbone (C). Il s'avère que ce matériau offre une bien meilleure sélectivité d'attaque à la gravure plasma que les masques en carbone seul. Noté ci-après B:C, le bore dopé au carbone offre typiquement un gain en sélectivité d'un facteur trois par rapport à un masque dur standard fait de carbone seul. Il permet donc de réduire considérablement l'épaisseur de masque dur nécessaire au transfert des motifs et de réduire dans les mêmes proportions le facteur de forme des motifs du masque. L'épaisseur du masque peut alors être réduite, ce qui permet de réduire voire d'éviter le repliement des motifs fins du masque sur eux-mêmes.

Ce type de matériau (B:C) peut par exemple être déposé par PECVD. La gravure du masque dur lui-même, c'est-à-dire le transfert préalable des motifs dans le masque peut se faire à l'aide d'une chimie fluorocarbonée dans un plasma formé dans un réacteur de gravure dit CCP, acronyme de l'anglais « capacitive coupled plasma » c'est-à-dire « plasma à couplage capacitif ».

Cependant, il est souvent avantageux de graver les matériaux sous jacents au masque dans un réacteur dit ICP, acronyme de l'anglais « inductive coupled plasma » c'est-à-dire « plasma à couplage inductif ». Un changement de réacteur en cours d'opération poserait de nombreux problèmes en raison des manipulations à effectuer qui seraient difficilement compatibles avec l'industrialisation du procédé. Un tel changement entraînerait de toute façon un fort ralentissement du débit de la ligne de fabrication s'il devait être mis en oeuvre. Il est donc important de pouvoir transférer les motifs dans le masque dur de bore dopé au carbone dans le même réacteur que celui servant à graver ensuite les couches fonctionnelles sous jacentes, c'est-à-dire dans un réacteur plasma à couplage inductif.

Comme déjà mentionné ci-dessus, une chimie de gravure à partir de produits fluorocarbonés de type tétrafluorure de carbone (CF4) ou octafluorobutane (C4F8) permettrait la gravure du B:C dans un réacteur CCP. Il a cependant été constaté qu'il est impossible d'utiliser une telle chimie dans un réacteur ICP car le taux de dissociation des espèces gazeuses FC, sous l'impact des électrons rapides du plasma, est insuffisant dans un réacteur ICP par rapport à un réacteur CCP. Dans le cas d'un réacteur ICP, la couche de passivation qui se forme normalement sur les flans des motifs gravés et qui protège latéralement ceux-ci tout au long de la gravure n'est pas assez importante. Les flans n'étant plus, ou insuffisamment, protégés cela entraîne une gravure isotrope du masque fait de bore dopé au carbone (B:C), ce qui est très préjudiciable à la définition des dimensions critiques (CD) comme on l'a vu dans le chapitre sur l'état de la technique.

Avant la présente invention, il n'existait donc pas de solution pour obtenir une gravure anisotrope dans un réacteur ICP, sans déformation du masque et sans avoir à changer de réacteur pour effectuer la gravure du masque et la gravure de la couche sous jacente. Or, cela est par exemple indispensable pour maîtriser la définition des dimensions critiques du masque dur en particulier pour la gravure de structures de type lignes/espaces telles qu'illustrées sur les figures 1a et 1b.

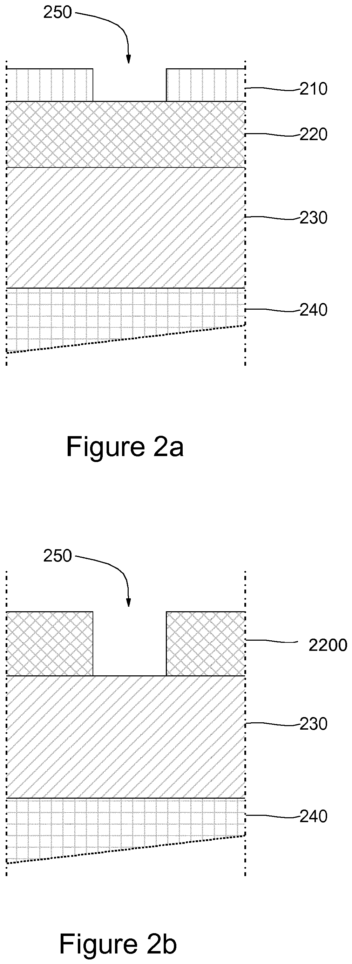

Les **figures 2a à 2d** décrivent les étapes d'un exemple de procédé de gravure selon l'invention qui permet qu'une gravure anisotrope des motifs d'un masque dur en bore dopé au carbone (B:C) puisse se faire dans un réacteur de gravure à couplage inductif (ICP).

La **figure 2a** décrit le résultat de la première étape où l'on transfère de façon conventionnelle, par photolithographie, des motifs dans une couche de résine photosensible 210 qui est disposée au dessus des couches à graver 240 et des couches qui vont former le masque dur : 220 et 230. L'invention prévoit en effet d'utiliser deux couches de masque dur : une couche 230 faite de bore dopé au carbone (B:C) comme discuté ci-dessus. Cette couche est elle-même recouverte d'une couche 220 destiné à former un premier masque dur également désigné masque dur intermédiaire 2200.

La couche 220 est avantageusement formée par un oxyde. Avantageusement elle est formée par un oxyde de silicium (SiO2) ou un oxyde de silicium nitruré de type SiOxNy, généralement noté SiON.

Selon l'invention, les motifs 250, initialement transférés dans la résine 210, vont ensuite être gravés successivement dans les différentes couches ci-dessus. Avantageusement, toutes les gravures suivantes sont effectuées dans un même réacteur plasma de gravure de type ICP, c'est-à-dire à couplage inductif.

La **figure 2b** montre le résultat de la gravure dans le réacteur ICP de la couche 220 dans laquelle est réalisée le masque dur intermédiaire 2200 fait d'oxyde (SiO2 ou SiON) et après enlèvement de la couche de résine 210.

La gravure de cette couche intermédiaire, avant la réalisation du masque dur de bore dopé au carbone 2300 est nécessaire puisque la gravure de ce maque dur 2300 à travers la couche de résine 210 n'est pas assez sélective. En effet si la couche 230 de bore dopé au carbone était gravée directement à travers le masque de résine 210, ce dernier serait consommé trop fortement pour définir dans la couche 230 de bore dopé au carbone des motifs de petites dimensions.

La gravure de la couche 220 se fait de façon classique à l'aide d'une chimie fluorocarbonée bien connue de l'homme du métier. Elle met en oeuvre des produits de gravure de type CF4/CHF3/O2, c'est-à-dire, respectivement tétrafluorure de carbone, trifluorométhane et oxygène.

L'épaisseur de la couche d'oxyde 220 est typiquement ajustée dans une gamme de valeurs allant de 30 nm à 100 nm. La couche 220 est d'autant plus épaisse que la couche sous jacente 230, faite de B:C, est elle-même plus épaisse.

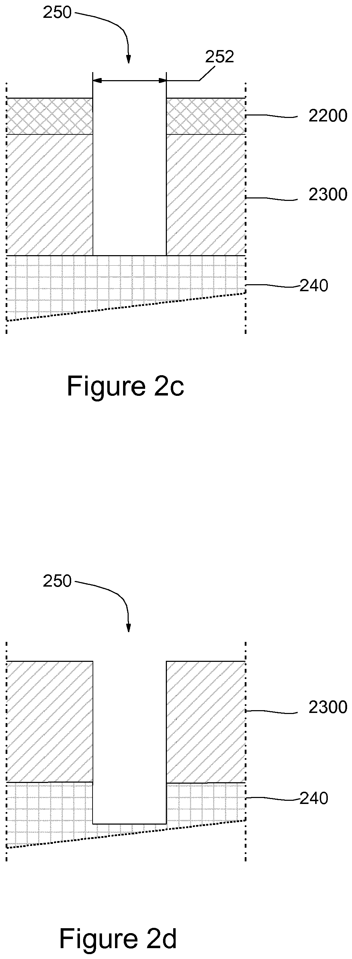

La **figure 2c** montre le résultat de la gravure effectuée dans le réacteur ICP et à travers le masque dur intermédiaire 2200 obtenu à l'issue de l'étape décrite dans la figure 2b. Cette gravure est appliquée à la deuxième couche 230 pour former le masque dur de bore dopé au carbone (B:C) 2300.

Une composition avantageuse du matériau est: 50% bore, 20% hydrogène, 30% carbone. Plus généralement, la quantité de bore peut varier entre 20% et 60% et de préférence entre 40% et 55%. La proportion de carbone est comprise entre 15% et 60% et de préférence entre 20% et 50%. La proportion d'hydrogène est comprise entre 5% et 40% et de préférence entre 10% et 30%.

Avec ces pourcentages et notamment cette proportion de bore, il s'est avéré que le masque présente une résistance à la gravure significativement améliorée. On augmente ainsi la sélectivité et donc la précision de la gravure.

L'hydrogène provient de la réaction de formation du masque qui fait typiquement réagir des éléments BₓH_{y} avec des éléments C_{z}Hₘ pour donner un matériau de type BₐC_{b}H_{c}, où x, y, z, m, a, b, c sont les proportions molaires de chaque élément dans la composition.

Le matériau est déposé par PECVD c'est-à-dire « plasma enhanced chemical vapor deposition ». La concentration de bore permet de jouer sur la sélectivité lors de la gravure de la couche 240. Plus la concentration de bore sera importante, meilleure sera la sélectivité, c'est-à-dire que cela permettra de graver la couche 240 plus vite que la couche 230 formant le masque dur 2300.

Dans la présente description les proportions sont des proportions molaires.

L'épaisseur de la couche 230 de bore dopé au carbone est typiquement ajustée dans une gamme de valeurs allant de 50 nm à 400 nm. Comme mentionné ci-dessus, si la couche 230 est épaisse, par exemple 400 nm, on choisit d'avoir une couche d'oxyde 220 (SiO2 par exemple) également épaisse, par exemple 100 nm.

De manière générale ces épaisseurs sont choisies pour qu'il n'y ait pas consommation totale du masque dur intermédiaire 2200 pendant la gravure du masque dur de bore dopé au carbone 2300. Ainsi, l'épaisseur à graver dans la couche 240 conditionne l'épaisseur du matériau 2300 à graver qui elle-même conditionne l'épaisseur du matériau 2200.

La gravure de la couche 230 faite de B:C se fait de façon anisotrope dans le réacteur ICP dans les conditions décrites ci-après. On notera ici que le procédé est adaptable quelle que soit l'épaisseur de matériau B:C utilisé et quelles que soient les dimensions 252 des motifs à graver qui pourront variées dans une large gamme de valeurs allant d'un dizaine de nanomètres à plusieurs centaines de nanomètres.

La chimie utilisée dans le graveur ICP pour obtenir ce résultat est de type Cl2/Ar/O2 c'est-à-dire Chlore/Argon/Oxygène. L'oxygène peut être remplacé par du dioxyde de soufre (SO2) ou de l'oxysulfure de carbone (COS). Et il y a également ajout d'un gaz fluoré de type NF3 ou SF6 par exemple, soit respectivement, du trifluorure d'azote ou de l'hexafluorure de soufre.

Les espèces précédentes, sous forme gazeuse, sont mises en oeuvre dans les conditions résumées dans le tableau suivant. Ces conditions ne sont qu'un exemple de réalisation et ne sont pas limitatifs. Les débits sont mesurés en sccm acronyme de l'anglais « standard cubic centimeters per minute » c'est-à-dire « centimètres cube par minute » dans des conditions « standard » de température et de pression.

| Espèce : | Débit en sccm : | Conditions : |
|---|---|---|
| Chlore Cl2 | 5 à 200 | Le rôle du chlore est de passiver les flancs par formation d'espèces C-Cl. Le chlore est un élément servant également à la gravure du matériau B:C. Un excès de chlore peut entraîner un profile trop pentu et une consommation trop importante du masque dur intermédiaire fait de SiON ou SiO2. |
| Oxygène 02 | 20 à 60 | L'oxygène permet un gain en sélectivité par rapport au masque dur SiON ou SiO2 et permet de graver le matériau B:C dix fois moins vite qu'avec le Chlore. Cependant, un excès d'oxygène dans le rapport O2/Cl2 peut entraîner un phénomène de micro masquage. On obtient alors une rugosité importante. Des gaz à base d'oxygène tels que COS ou SO2 peuvent remplacer l'oxygène. Les quantités de SO2 ou COS utilisées sont similaires à celles de l'oxygène. |
| Chimie fluorée SF6 ou NF3 | 5 à 30 | Le fluor permet de contrôler le profile et de graver le matériau B:C. Trop de fluor engendre cependant une perte de sélectivité vis a vis du masque dur et donne des profiles isotropes. Avec du fluor seul, c'est-à-dire sans Cl2, on obtient alors une gravure complètement isotrope car il n'y a plus formation par le chlore de la couche de passivation sur les flancs, la formation des espèces C-Cl mentionnées ci-dessus ne s'effectuant plus. |
| Argon Ar | 500 | L'argon a pour rôle de faciliter la dissociation des espèces du plasma. |

| Puissances électriques en watts : | | |
|---|---|---|
| Source | 100-1000 | La puissance source permet de jouer sur la dissociation du plasma. |
| Bias | 50-500 | Le « bias » ou polarisation permet d'augmenter la vitesse de gravure du matériau B:C. Cependant, une puissance bias trop élevée engendre une perte de sélectivité et des profiles pentus en raison du redepôt des produits de réaction de gravure sur les flancs des motifs. Au contraire, une puissance faible de bias améliore la sélectivité vis à vis du masque dur SiO2 ou SiON mais il n'y a plus alors formation d'une couche de passivation suffisante sur les flancs et on obtient des profiles isotropes. |

| Autres paramètres : | | |
|---|---|---|
| Pression | | 5-100 milli Torr |
| Température | | 10-100°C |
| Temps de gravure | | D'une trentaine de secondes à quelques minutes. Le temps de gravure dépend de l'épaisseur a graver |

On voit dans le tableau ci-dessus que la gravure du masque 2300 de bore dopé au carbone (B:C) est donc un compromis entre le ratio des gaz Cl2/O2/F qui permettent d'obtenir des profiles anisotropes et une sélectivité suffisante vis a vis du masque dur intermédiaire 2200 fait de SiO2 ou de SiON.

Par exemple, les conditions optimales pour graver une couche faite de B:C, d'une épaisseur de 150 nm, sont : puissance source, 500 W ; puissance bias, 100 W ; pression, 20 milli Torr ; débit 02, 35 sccm ; débit Cl2, 15 sccm ; débit Ar, 200 sccm ; débit SF6, 10sccm ; temps de gravure 80 secondes.

La chimie de gravure pour graver la couche 240 dépend de sa composition. Par exemple, si cette couche est du silicium, la chimie de gravure pourra être : débit SF6, 35 sccm ; débit CH2F2, 25 sccm ; débit He, 200 sccm ; débit N2, 45 sccm ; puissance bias 60 W ; puissance source 450 W ; pression 6 milli Torr.

De manière plus générale, ladite couche à graver est faite à base d'un matériau semi-conducteur pris parmi le silicium, le germanium, le silicium-germanium ou est faite à base d'un oxyde d'un matériau semi-conducteur pris parmi le silicium, le germanium ou le silicium-germanium.

La **figure 2d** illustre la gravure des motifs 250 dans les couches à graver 240. Dans de nombreux cas, ces couches seront des couches fonctionnelles. Possiblement mais non limitativement, elles peuvent être réalisées dans tous les matériaux couramment utilisés en microélectronique et notamment ceux issus du silicium, tels que le silicium polycristallin, l'oxyde de silicium, le silicium-germanium ou en germanium etc. Dans le cadre de l'invention la gravure se fait à l'aide du masque dur 2300 en bore dopé au carbone qui peut être beaucoup moins épais que les masques durs traditionnels en carbone évitant ainsi les problèmes de déformation décrits en référence aux figures 1a et 1b. On notera que la couche 220 formant le premier masque 2200 est partiellement consommée pendant la gravure de la couche 230 et est complètement consommée à l'issue de la gravure de la couche 240.

## Revendications

1. Procédé de gravure anisotrope de motifs (250) dans au moins une couche à graver (240) à travers un masque dur (2300) comprenant du carbone dans un réacteur de gravure plasma à couplage inductif (ICP), le masque dur (2300) étant fait de bore dopé au carbone (B:C), le procédé comprenant, préalablement à la gravure anisotrope des motifs (250) dans ladite couche à graver (240) à travers le masque dur de bore dopé au carbone (B:C) (2300), les étapes suivantes:
- réalisation d'un masque dur intermédiaire (2200) situé sur une couche de bore dopé au carbone (230) destinée à former le masque dur (2300) fait de bore dopé au carbone (B:C),
- gravure de la couche de bore dopé au carbone (B:C) (2300) à travers le masque dur intermédiaire (2200) pour former le masque dur fait de bore dopé au carbone (B:C) (2300), la gravure du masque dur de bore dopé au carbone (B:C) (2300) étant réalisée dans un plasma fait d'espèces comprenant : du chlore (Cl2), de l'argon (Ar), un gaz à base d'oxygène et un gaz fluoré,
la réalisation du masque dur intermédiaire (2200) et la gravure du masque dur fait de bore dopé au carbone (B:C) (2300) étant réalisées dans ledit réacteur de gravure plasma à couplage inductif (ICP).

2. Procédé selon la revendication précédente dans lequel le chlore (Cl2) est introduit avec un débit compris entre 2 et 300 sccm et de préférence entre 5 et 200 sccm.

3. Procédé selon l'une quelconque des deux revendications précédentes dans lequel l'argon (Ar) est introduit avec un débit compris entre 300 et 700 sccm.

4. Procédé selon l'une quelconque des trois revendications précédentes dans lequel le gaz à base d'oxygène est pris parmi : l'oxygène (02), le dioxyde de soufre (SO2) ou l'oxysulfure de carbone (COS).

5. Procédé selon l'une quelconque des quatre revendications précédentes dans lequel le gaz à base d'oxygène est de l'oxygène (02) et il est introduit avec un débit compris entre 10 à 80 sccm

6. Procédé selon l'une quelconque des cinq revendications précédentes dans lequel le gaz fluoré est pris parmi : le trifluorure d'azote (NF3) ou l'hexafluorure de soufre (SF6).

7. Procédé selon la revendication précédente dans lequel le gaz fluoré est introduit avec un débit compris entre 3 à 50 sccm et préférence entre 5 et 30 sccm.

8. Procédé selon l'une quelconque des revendications précédentes dans lequel l'épaisseur du masque dur fait de bore dopé au carbone (2300), est comprise entre 1 et 5 fois la profondeur des motifs gravés dans la couche fonctionnelle.

9. Procédé selon l'une quelconque des revendications précédentes dans lequel dans le masque dur fait de bore dopé au carbone (2300), la proportion de carbone est comprise entre 20% et 50%.

10. Procédé selon l'une quelconque des revendications 1 à 8, dans lequel dans le masque dur fait de bore dopé au carbone (2300) comprend du bore (B), du carbone (C) et de l'hydrogène (H) et dans lequel la proportion de bore (B) est comprise entre 20% et 60% et de préférence entre 40% et 55%, dans lequel la proportion de carbone (C) est comprise entre 15% et 60% et de préférence entre 20% et 50%, et dans lequel la proportion d'hydrogène (H) est comprise entre 5% et 40% et de préférence entre 10% et 30%.

11. Procédé selon l'une quelconque des revendications précédentes dans lequel le masque dur intermédiaire (2200) est fait d'un oxyde.

12. Procédé selon l'une quelconque des revendications précédentes dans lequel la réalisation du masque dur intermédiaire (2200) comprend une gravure de la couche intermédiaire (220) dans un plasma fluorocarboné à base de tétrafluorure de carbone (CF4) ou d'octafluorobutane (C4F8), de trifluorométhane (CHF3) et d'oxygène.

13. Procédé selon l'une quelconque des revendications précédentes dans lequel la réalisation du masque dur intermédiaire (2200) comprend une gravure de la couche intermédiaire (220) à travers un masque de résine située sur la couche intermédiaire (220).

14. Procédé selon l'une quelconque des revendications précédentes dans lequel ladite couche à graver (240) est faite à base d'un matériau semi-conducteur pris parmi le silicium, le germanium, le silicium-germanium ou est faite à base d'un oxyde d'un matériau semi-conducteur pris parmi le silicium, le germanium ou le silicium-germanium.

15. Procédé selon l'une quelconque des revendications précédentes dans lequel le procédé est réalisé à partir d'un empilement de couches comprenant ladite couche graver (240) sur laquelle sont successivement disposées : la couche de bore dopé au carbone (230), une couche intermédiaire (220) dans laquelle le masque dur intermédiaire (2200) est destiné à être réalisé, une couche de résine (210), la couche de bore dopé au carbone (230) étant disposée directement au contact de ladite couche à graver (240) et de la couche intermédiaire (220).

## Patentansprüche

1. Verfahren zum anisotropen Ätzen von Mustern (250) in zumindest eine zu ätzende Schicht (240) durch eine Kohlenstoff enthaltende Hartmaske (2300) in einem induktiv gekoppelten Plasmaätzreaktor (ICP), wobei die Hartmaske (2300) aus kohlenstoffdotiertem Bor (B:C) hergestellt ist, wobei das Verfahren vor dem anisotropen Ätzen der Muster (250) in die Schicht (240), die durch die Hartmaske (2300) aus kohlenstoffdotiertem Bor (B:C) geätzt werden sollen, die nachstehenden Schritte umfasst:
- Herstellen einer Zwischenhartmaske (2200) auf einer Schicht (230) aus kohlenstoffdotiertem Bor zur Bildung der Hartmaske (2300) aus kohlenstoffdotiertem Bor (B:C),
- Ätzen der Schicht (2300) aus kohlenstoffdotiertem Bor (B:C) durch die Zwischenhartmaske (2200), um die Hartmaske (2300) aus kohlenstoffdotiertem Bor (B:C) zu bilden, wobei das Ätzen der Hartmaske (2300) aus kohlenstoffdotiertem Bor (B:C) in einem Plasma erfolgt, das aus Spezies hergestellt ist, die Chlor (Cl2), Argon (Ar), sauerstoffbasiertes Gas und fluorhaltiges Gas umfassen,
wobei das Herstellen der Zwischenhartmaske (2200) und das Ätzen der Hartmaske (2300) aus kohlenstoffdotiertem Bor (B:C) in dem induktiv gekoppelten Plasmaätzreaktor (ICP) erfolgen.

2. Verfahren nach dem vorangehenden Anspruch, wobei das Chlor (Cl2) mit einer Strömungsrate zwischen 2 und 300 sccm und vorzugsweise zwischen 5 und 200 sccm eingeleitet wird.

3. Verfahren nach einem der beiden vorangehenden Ansprüche, wobei das Argon (Ar) mit einer Strömungsrate zwischen 300 und 700 sccm eingeleitet wird.

4. Verfahren nach einem der drei vorangehenden Ansprüche, wobei das sauerstoffbasierte Gas aus Sauerstoff (02), Schwefeldioxid (SO2) oder Kohlenstoffoxysulfid (COS) ausgewählt wird.

5. Verfahren nach einem der vier vorangehenden Ansprüche, wobei das sauerstoffbasierte Gas Sauerstoff (02) ist und mit einer Strömungsrate zwischen 10 und 80 sccm eingeleitet wird.

6. Verfahren nach einem der fünf vorangehenden Ansprüche, wobei das fluorhaltige Gas aus Stickstofftrifluorid (NF3) oder Schwefelhexafluorid (SF6) ausgewählt wird.

7. Verfahren nach dem vorangehenden Anspruch, wobei das fluorhaltige Gas mit einer Strömungsrate zwischen 3 und 50 sccm und vorzugsweise zwischen 5 und 30 sccm eingeleitet wird.

8. Verfahren nach einem der vorangehenden Ansprüche, wobei die Dicke der Hartmaske (2300) aus kohlenstoffdotiertem Bor das 1- bis 5-fache der Tiefe der in die Funktionsschicht geätzten Muster beträgt.

9. Verfahren nach einem der vorangehenden Ansprüche, wobei in der Hartmaske (2300) aus kohlenstoffdotiertem Bor der Kohlenstoffanteil zwischen 20% und 50% beträgt.

10. Verfahren nach einem der Ansprüche 1 bis 8, wobei die Hartmaske (2300) aus kohlenstoffdotiertem Bor Bor (B), Kohlenstoff (C) und Wasserstoff (H) enthält und der Anteil an Bor (B) zwischen 20% und 60% und vorzugsweise zwischen 40 % und 55 % beträgt, wobei der Anteil an Kohlenstoff (C) zwischen 15% und 60% und vorzugsweise zwischen 20 % und 50 % beträgt und wobei der Anteil an Wasserstoff (H) zwischen 5 % und 40 % und vorzugsweise zwischen 10 % und 30 % beträgt.

11. Verfahren nach einem der vorangehenden Ansprüche, wobei die Zwischenhartmaske (2200) aus einem Oxid besteht.

12. Verfahren nach einem der vorangehenden Ansprüche, wobei das Herstellen der Zwischenhartmaske (2200) ein Ätzen der Zwischenschicht (220) in einem Fluorkohlenstoffplasma auf Basis von Kohlenstofftetrafluorid (CF4) oder Octafluorbutan (C4F8), Trifluormethan (CHF3) und Sauerstoff umfasst.

13. Verfahren nach einem der vorangehenden Ansprüche, wobei das Herstellen der Zwischenhartmaske (2200) ein Ätzen der Zwischenschicht (220) durch eine auf der Zwischenschicht (220) liegenden Harzmaske umfasst.

14. Verfahren nach einem der vorangehenden Ansprüche, wobei die zu ätzende Schicht (240) auf Basis eines Halbleitermaterials hergestellt ist, ausgewählt aus Silizium, Germanium, Silizium-Germanium, oder auf Basis von Oxid eines Halbleitermaterials hergestellt ist, ausgewählt aus Silizium, Germanium oder Silizium-Germanium.

15. Verfahren nach einem der vorangehenden Ansprüche, wobei das Verfahren ausgehend von einer Stapelung von Schichten erfolgt, die die zu ätzende Schicht (240) umfasst, auf der nacheinander angeordnet sind: die Schicht aus kohlenstoffdotiertem Bor (230), eine Zwischenschicht (220), in der die Zwischenhartmaske (2200) erzeugt werden soll, eine Harzschicht (210), wobei die Schicht aus kohlenstoffdotiertem Bor (230) direkt in Kontakt mit der zu ätzenden Schicht (240) und der Zwischenschicht (220) angeordnet ist.

## Claims

1. Method for anisotropic etching of patterns (250) in at least one layer to be etched (240) through a hard mask (2300) comprising carbon in an inductively coupled plasma etching reactor (ICP), the hard mask (2300) being made of boron doped with carbon (B:C), the method comprising, before the anisotropic etching of the patterns (250) in said layer to be etched (240) through the hard mask of boron doped with carbon (B:C) (2300), the following steps:
- creating an intermediate hard mask (2200) located on a layer of boron doped with carbon (230) intended to form the hard mask (2300) made of boron doped with carbon (B:C),
- etching the layer of boron doped with carbon (B:C) (2300) through the intermediate hard mask (2200) in order to form the hard mask made of boron doped with carbon (B:C) (2300), the etching of the hard mask of boron doped with carbon (B:C) (2300) being carried out in a plasma made of species comprising: chlorine (CI2), argon (Ar), a gas containing oxygen and a fluorinated gas,
the creation of the intermediate hard mask (2200) and the etching of the hard mask made of boron doped with carbon (B:C) (2300) being carried out in said inductively coupled plasma etching reactor (ICP).

2. Method according to the previous claim, wherein the chlorine (CI2) is introduced with a flow rate between 2 and 300sccm and preferably between 5 and 200sccm.

3. Method according to any one of the previous two claims, wherein the argon (Ar) is introduced with a flow rate between 300 and 700sccm.

4. Method according to any one of the previous three claims, wherein the gas containing oxygen is chosen from: oxygen (O2), sulphur dioxide (SO2) and carbon oxysulfide (COS).

5. Method according to any one of the previous four claims, wherein the gas containing oxygen is oxygen (O2) and it is introduced with a flow rate between 10 and 80sccm.

6. Method according to any one of the previous five claims, wherein the fluorinated gas is chosen from: nitrogen trifluoride (NF3) and sulphur hexafluoride (SF6).

7. Method according to the previous claim, wherein the fluorinated gas is introduced with a flow rate between 3 and 50sccm and preferably between 5 and 30sccm.

8. Method according to any one of the previous claims, wherein the thickness of the hard mask made of boron doped with carbon (2300), is between 1 and 5 times the depth of the patterns etched in the functional layer.

9. Method according to any one of the previous claims, wherein in the hard mask made of boron doped with carbon (2300), the proportion of carbon is between 20% and 50%.

10. Method according to any one of claims 1 to 8, wherein in the hard mask made of boron doped with carbon (2300) comprises boron (B), carbon (C) and hydrogen (H) and wherein the proportion of boron (B) is between 20% and 60% and preferably between 40% and 55%, wherein the proportion of carbon (C) is between 15% and 60% and preferably between 20% and 50%, and wherein the proportion of hydrogen (H) is between 5% and 40% and preferably between 10% and 30%.

11. Method according to any one of the previous claims, wherein the intermediate hard mask (2200) is made of an oxide.

12. Method according to any one of the previous claims, wherein the creation of the intermediate hard mask (2200) comprises etching of the intermediate layer (220) in a fluorocarbon plasma containing carbon tetrafluoride (CF4) or octafluorobutane (C4F8), trifluoromethane (CHF3) and oxygen.

13. Method according to any one of the previous claims, wherein the creation of the intermediate hard mask (2200) comprises etching of the intermediate layer (220) through a mask of resin located on the intermediate layer (220).

14. Method according to any one of the previous claims, wherein said layer to be etched (240) is made from a semiconductor material chosen from silicon, germanium, silicon-germanium or is made from an oxide of a semiconductor material chosen from silicon, germanium and silicon-germanium.

15. Method according to any one of the previous claims, wherein the method is carried out using a stack of layers comprising said layer etch (240) on which the following are successively positioned: the layer of boron doped with carbon (230), an intermediate layer (220) in which the intermediate hard mask (2200) is intended to be made, a layer of resin (210), the layer of boron doped with carbon (230) being positioned directly in contact with said layer to be etched (240) and the intermediate layer (220).
